# EUROPÄISCHE PATENTSCHRIFT

(11) **EP 1 856 960 B1**
(45) Veröffentlichungstag und Bekanntmachung des Hinweises auf die Patenterteilung: **17.10.2012**
(21) Anmeldenummer: 06841513.2
(22) Anmeldetag: 20.12.2006
(51) Int. Cl.: H05K 13/04

(54) **POSITIONIERARM FÜR EINEN BESTÜCKAUTOMATEN ZUM BESTÜCKEN VON SUBSTRATEN MIT ELEKTRISCHEN BAUTEILEN**
POSITIONING ARM FOR AN AUTOMATIC PLACEMENT MACHINE FOR FITTING ELECTRICAL COMPONENTS TO SUBSTRATES
BRAS DE POSITIONNEMENT POUR UN AUTOMATE D'IMPLANTATION POUR IMPLANTER DES COMPOSANTS ÉLECTRIQUES SUR DES SUBSTRATS

(30) Priorität: 09.02.2006 DE 102006006070
(43) Veröffentlichungstag der Anmeldung: 21.11.2007
(73) Patentinhaber: ASM Assembly Systems GmbH & Co. KG, 81379 München (DE)
(72) Erfinder: CONRAD, Robert, 82054 Sauerlach (DE); DREXEL, Peter, 90552 Röthenbach an der Pegnitz (DE); MEHDIANPOUR, Mohammad, 81829 München (DE)
(74) Vertreter: Patentanwälte Bals & Vogel
(86) Internationale Anmeldenummer: PCT/EP2006/070013
(87) Internationale Veröffentlichungsnummer: WO 2007/090483

(56) Entgegenhaltungen:
- WO-A-00/36896
- DE-A1- 10 054 136

## Beschreibung

Die Erfindung betrifft einen Positionierarm für einen Bestückkopf eines Bestückautomaten zum Bestücken von Substraten mit elektrischen Bauteilen und einen Bestückautomaten mit einem derartigen Positionierarm, wie im DE-A-10054136.

In der Bestücktechnik werden Substrate in einem Bestückautomaten mittels eines Bestückkopfes mit elektrischen Bauteilen versehen. Der Bestückkopf wird gewöhnlich mittels eines verfahrbaren Positionierarms in einer Bestückebene über dem zu bestückenden Substrat bewegt. Bei dem Positionierarm kann es sich um einen Stahlträger handeln, welcher zumindest an einem Ende mit einem Antriebssystem, beispielsweise einem Linearmotor, gekoppelt ist. Zur Anbindung an das Antriebssystem muss der Stahlträger an dieser Seite einen Formkörper bzw. ein Verbindungselement, wie beispielsweise ein Flansch, aufweisen. Dieses separate Verbindungselement muss dabei aufwändig und kostenintensiv an dem Stahlträger, beispielsweise durch Schraubverbindungen, befestigt werden. Die Schraubverbindungen sind dabei nie ganz spielfrei, was sich negativ auf die Positioniergenauigkeit auswirkt. Ferner verursachen Schraubverbindungen eine deutliche Zunahme des Gewichts des Positionierarms.

Es ist deshalb die Aufgabe der vorliegenden Erfindung, einen Positionierarm für einen Bestückautomaten und einen Bestückautomaten zu liefern, welche sich durch eine einfache Herstellung und eine hohe Positioniergenauigkeit auszeichnen.

Diese Aufgabe wird durch den Positionierarm und den Bestückautomaten gemäß den unabhängigen Ansprüchen gelöst. Vorteilhafte Ausgestaltungen sind Gegenstand der abhängigen Ansprüche.

Ein Positionierarm gemäß dem Anspruch 1 weist einen Grundkörper aus Stahl und einen daran befestigten Formkörper aus Aluminium auf, wobei der Formkörper an den Grundkörper angegossen ist. Da die Gießtemperatur bzw. Schmelztemperatur von Aluminium deutlich niedriger liegt als die von Stahl, kann das Angießen des Formkörpers and den Grundkörper beispielsweise dadurch geschehen, dass der feste Grundkörper zumindest teilweise in eine entsprechende Gussform für den Formkörper, welche Aluminiumschmelze enthält, getaucht wird. Der Stahl erwärmt sich dabei auf die Gießtemperatur des Aluminiums und dehnt sich aus, ohne dabei selbst zu schmelzen. Beim Abkühlen erstarrt das Aluminium und wird fest. Da der Formkörper aus Aluminium bei weiteren Abkühlen stärker schrumpft als der Grundkörper aus Stahl, baut sich an dem Abschnitt, an dem der Formkörper an den Grundkörper angegossen ist, eine hohe Druckspannung auf. Dadurch entsteht zwischen dem Formkörper und dem Grundkörper eine sehr starke Reibschlussverbindung. Bei diesem Positionierarm sind keine aufwändigen Schraubverbindungen zwischen dem Formkörper und dem Grundkörper mehr nötig. Die Herstellung ist einfach durchzuführen, Da der Formkörper gegossen wird, können beliebige Formen realisiert werden, was eine hohe Flexibilität mit sich bringt. Ferner ist die Verbindung zwischen dem Grundkörper und dem Formkörper absolut spielfrei und extrem fest. Somit widersteht der Positionierarm auch den hohen mechanischen Beanspruchungen während des Positioniervorgangs. Auch die Positioniergenauigkeit wird durch die spielfreie Verbindung gesteigert. Ferner ergeben sich im Vergleich zu Schraubverbindungen Gewichtsvorteile.

In einer Ausgestaltung nach Anspruch 2 handelt es sich bei dem Grundkörper um ein Profilteil aus Stahl. Derartige handelsübliche Profilteile sind sehr günstig in der Anschaffung, weisen eine hohe Steifigkeit auf und sind in verschiedenen Querschnittsformen erhältlich. Dadurch ergeben sich vor allem bezüglich der Kosten Vorteile.

Der Positionierarm kann gemäß Anspruch 3 auch dahingehend ausgestaltet werden, dass der Grundkörper in einem Abschnitt, in dem der Formkörper angegossen ist, Strukturelemente aufweist, welche eine formschlüssige Verbindung zwischen dem Grundkörper und dem angegossenen Formteil gewährleisten. Bei den Strukturelementen kann es sich beispielsweise um einen T-Anker am Ende des Grundkörpers oder um Fortsätze an den Seitenwänden des Grundkörpers oder Löcher bzw. Vertiefungen am Grundkörper handeln. Dadurch, dass die Srukturelemente von dem Aluminium umgossen werden, entsteht ein Formschluss, welcher zusätzlich zu dem sich ergebenden Reibschluss für eine noch festere und sichere Verbindung sorgt.

Ein Bestückautomat gemäß Anspruch 4 weist einen Positionierarm nach einem der Ansprüche 1 bis 3 auf. Der Bestückautomat zeichnet sich daher durch geringere Fertigungs- und Anschaffungskosten sowie eine hohe Positioniergenauigkeit und ein geringeres Gewicht des Positioniersystems auf. Die bezüglich der Ansprüche 1 bis 3 genannten Vorteile gelten analog.

Im Folgenden wird ein Ausführungsbeispiel der vorliegenden Erfindung mit Bezug auf die beigefügten Figuren näher erläutert. In den Figuren sind:
Figur 1 eine schematische Darstellung eines Ausführungsbeispiels des Bestückautomaten mit einem Positionierarm,
Figur 2 und Figur 3 jeweils schematische Teilansichten eines Ausführungsbeispiels des Positionierarms.

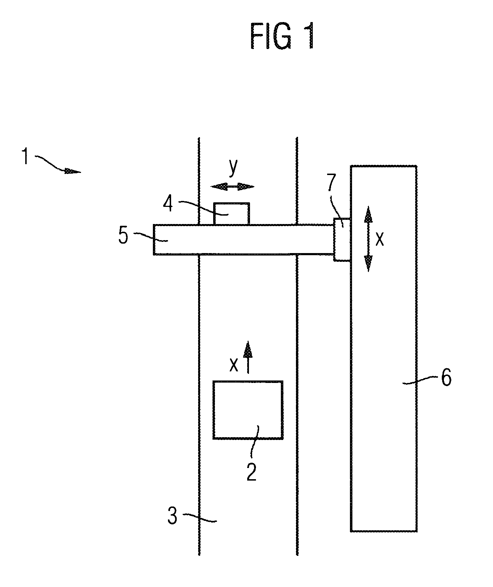

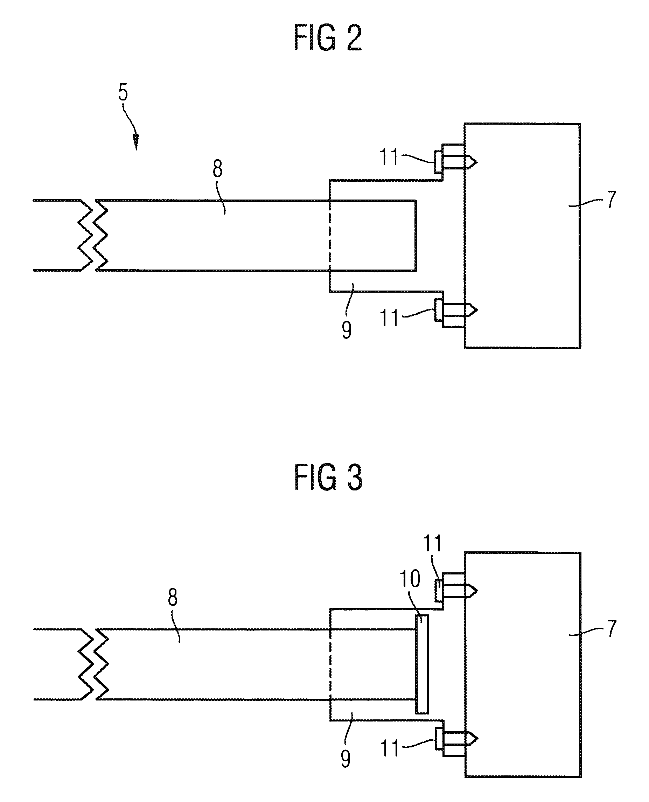

In Figur 1 ist ein Ausführungsbeispiel eines Bestückautomaten 1 schematisch dargestellt. Ein zu bestückendes Substrat 2 wird mittels eines Transportbandes 3 in einer Transportrichtung (Pfeil x) zu einem Bestückbereich des Bestückautomaten 1 transportiert, um dort mittels eines Bestückkopfes 4 mit elektrischen Bauteilen versehen zu werden. Der Bestückkopf 4 wird mittels eines erfindungsgemäßen Positionierarms 5, welcher anhand der Figuren 2 und 3 näher beschrieben wird, in einer zum Substrat 2 parallelen Ebene bewegt. Der Bestückkopf 4 ist in einer zur Transportrichtung quergerichteten Richtung (Pfeil y) verschiebbar am Positionierarm 5 gelagert. Ferner ist der Positionierarm 5 in der Transportrichtung (Pfeil x) verschiebbar am einem Chassis 6 des Bestückautomaten 1 gelagert. Die Antriebe 7 sowohl des Bestückkopfes 4 am Positionierarm 5 als auch des Positionierarms 5 am Chassis 6 können mittels eines Linearmotors , eines Riemenantriebs oder eines Spindelantriebs realisiert werden.

Zur Anbindung des Positionierarms an den Antrieb ist es notwendig, dass der Positionierarm über entsprechende Verbindungselemente, wie beispielsweise einen Flansch, verfügt. Die Ausbildung eines derartigen Flansches am Positionierarm erweist sich bei bekannten Positionierarmen als sehr aufwändig, da der Flansch als gesonderter Formkörper, beispielsweise mittels Schraubverbindungen, an einen Grundkörper des Positionierarms befestigt werden muss. An die Verbindung zwischen dem Formkörper und dem Grundkörper sind sehr hohe Anforderungen bezüglich Stabilität und Präzision gestellt.

Die Figuren 2 und 3 stellen jeweils vergrößerte Teilansichten von Ausführungsbeispielen des in Fig. 1 gezeigten Positionierarms 5 dar.

Der Positionierarm 5 besteht aus einem Grundkörper 8 und einem daran befestigten Formkörper 9 (gestrichelt dargestellt). Bei dem Grundkörper 8 kann es sich um ein handelsübliches, kostengünstiges Profilteil aus Stahl, wie beispielsweise einem Vierkant-Hohlprofil, handeln, welches eine hohe Stabilität und Steifigkeit aufweist. Der Formkörper 9 weist Aluminium auf und besteht daher aus Aluminium oder aus einer Aluminiumlegierung. Zwischen dem Formkörper 9 und dem Grundkörper 8 besteht eine äußerst feste Reibschlussverbindung (Fig. 2) und optional eine zusätzliche Formschlussverbindung. Diese Reibschlussverbindung und Formschlussverbindung können folgendermaßen erreicht werden:

Der Grundkörper 8 aus Stahl wird in eine mit flüssigem Aluminium oder mit einer flüssigen Aluminiumlegierung gefüllte Gießform (nicht dargestellt) des Formkörpers 9 zumindest teilweise getaucht. Im Falle der Ausführungsbeispiele geschieht dies mit dem Ende des Grundkörpers 8, an welchem der Linearmotor 7 befestigt werden soll. Dabei erwärmt sich der Grundkörper 8 in diesem Bereich auf die Gießtemperatur des Aluminiums, ohne dabei zu schmelzen. Dies liegt daran, dass Aluminium eine deutlich niedrigere Schmelztemperatur als Stahl aufweist. Durch entsprechende Gestaltung der Gießform für den Formkörper 9, kann dieser sehr einfach und flexibel entsprechend der jeweiligen individuellen Verhältnisse ausgebildet werden, wodurch eine sehr hohe Flexibilität erreicht wird. Beim Abkühlen des Aluminiums schrumpft der Formkörper 9 aus Aluminium stärker als der Grundkörper 8 aus Stahl. Damit baut sich in dem Bereich des Grundkörpers 8, in dem er von dem Formkörper 9 umgossen ist, eine sehr hohe Druckspannung auf. Bei vollständiger Abkühlung und Erstarrung des Aluminiums ergibt sich durch die hohe Druckspannung eine sehr feste, wartungsfreie Reibschlussverbindung zwischen dem Formkörper 9 und dem Grundkörper 8. Auf die oben dargestellte Weise kann der Formkörper 9 an den Grundkörper 8 angegossen werden bzw. kann der Grundkörper 8 von dem Formkörper 9 zumindest teilweise umgossen werden.

Bei dem Ausführungsbeispiel gemäß Figur 3 ist in dem Abschnitt, in dem der Formkörper 9 an den Grundkörper 8 angegossen wird, ein Strukturelement 10 in Form einer überstehenden Abschlussplatte aus Stahl angebracht. Diese kann beispielsweise angeschweißt werden. Alternativ können weitere Strukturelemente 10, wie beispielsweise Löcher oder Erhöhungen (nicht dargestellt) in der Wandung des Grundkörpers 8, ausgebildet sein. Nach dem Umgießen dieses die Strukturelemente 10 aufweisenden Abschnitts des Grundkörpers 8 ergibt sich neben der Reibschlussverbindung zusätzlich eine Formschlussverbindung zwischen dem Formkörper 9 und dem Grundkörper 8. Dadurch wird die Verbindung zwischen dem Formkörper 9 und dem Grundkörper 8 noch weiter gefestigt.

Der Linearmotor 7 kann beispielsweise mittels Schrauben 11 am Positionierarm 5 befestigt werden. Dazu können am Formkörper 9 entsprechende Bohrungen vorgesehen sein.

Die Verbindung zwischen dem Grundkörper 8 und dem Formkörper 9 des oben beschriebenen Positionierarms 5 ist absolut spielfrei und sehr fest. Die Positionierung des Bestückkopfes 4 erfolgt daher mit sehr hoher Präzision. Der Herstellung des Positionierarms 5 ist kostengünstig. Der erfindungsgemäße Positionierarm 5 zeichnet sich augrund der Reibschlussverbindung durch ein geringes Gewicht aus. Ferner ergibt sich durch den Gießvorgang eine hohe Flexibilität hinsichtlich der Formgebung des Formkörpers 9.

## Patentansprüche

1. Positionierarm (5) für einen Bestückkopf (4) eines Bestückautomaten (1) zum Bestücken von Substraten (2) mit elektrischen Bauteilen, welcher einen Grundkörper (8) aus Stahl und einen Formkörper (9) aus Aluminium aufweist, wobei der Formkörper (9) an den Grundkörper 8 angegossen ist.

2. Positionierarm (5) nach Anspruch 1, wobei es sich bei dem Grundkörper (8) um ein Profilteil handelt.

3. Positionierarm (5) nach Anspruch 1, wobei der Grundkörper (8) in einem Abschnitt, in dem der Formkörper (9) angegossen ist, Strukturelemente (10) aufweist, welche eine formschlüssige Verbindung zwischen dem Grundkörper (8) und dem angegossenen Formkörper (9) gewährleisten.

4. Bestückautomat (1) zum Bestücken von Substraten (2) mit elektrischen Bauteilen, mit einem Positionierarm (5) nach einem der Ansprüche 1 bis 3.

## Claims

1. A positioning arm (5) for a placement head (4) of a placement machine (1) for assembling electrical components on substrates (2), which comprises a base body (8) of steel and a shaped body (9) of aluminum, wherein the shaped body (9) is cast onto the base body 8.

2. The positioning arm (5) according to claim 1, wherein the base body (8) is a profile part.

3. The positioning arm (5) according to claim 1, wherein the base body (8) comprises, in a section in which the shaped body (9) is cast on, structural elements (10) which ensure a form-fit connection between the base body (8) and the cast-on shaped body (9).

4. A placement machine (1) for assembling electrical components on substrates (2), with a positioning arm (5) according to any one of claims 1 to 3.

## Revendications

1. Bras de positionnement (5) pour une tête d'implantation (4) d'un automate d'implantation (1) servant à implanter des composants électriques sur des substrats (2), qui présente un corps de base (8) en acier et un corps moulé (9) en aluminium, sachant que le corps moulé (9) est surmoulé sur le corps de base (8).

2. Bras de positionnement (5) selon la revendication 1, sachant que le corps de base (8) est une pièce profilée.

3. Bras de positionnement (5) selon la revendication 1, sachant que le corps de base (8) présente, dans une partie sur laquelle est surmoulé le corps moulé (9), des éléments de structuration (10) qui garantissent une liaison positive entre le corps de base (8) et le corps moulé (9) surmoulé.

4. Automate d'implantation (1) servant à implanter des composants électriques sur des substrats (2), avec un bras positionnement (5) selon l'une des revendications 1 à 3.
